# EUROPÄISCHE PATENTANMELDUNG

(11) **EP 1 003 218 A1**
(43) Veröffentlichungstag der Anmeldung: **24.05.2000**
(21) Anmeldenummer: 99122522.8
(22) Anmeldetag: 12.11.1999
(51) Int. Cl.: H01L 27/08, H01L 21/822, H01L 29/866, H01L 29/872, H01L 29/885

(54) **Halbleiteranordnungen mit einer Schottky-Diode und einer Diode mit einem hochdotierten Bereich und entsprechende Herstellungsverfahren**

(30) Priorität: 21.11.1998 DE 19853743
(71) Anmelder: Micronas Intermetall GmbH, 79108 Freiburg (DE)
(72) Erfinder: Krumrey, Joachim, Dipl.-Phys., 81669 München (DE); Igel, Günter, Dipl.-Ing., 79331 Teningen (DE)
(74) Vertreter: Schmitt, Hans, Dipl.-Ing.

(57) **Zusammenfassung**

Ein Halbleiter-Bauelement (1a) mit wenigstens einer hochdotierten Diode, insbesondere mit einer Zenerdiode oder einer Tunneldiode, und wenigstens einer parallel geschalteten Schottky Diode, welches ein hochdotiertes Substrat (4,4a) eines ersten Dotierungstyps aufweist, das bereichsweise von einer hochdotierten Schicht (6,15) eines zweiten Dotierungstyps zur Bildung eines pn-Übergangs (8,16) kontaktiert ist und auf dem eine niedrig dotierte Epitaxieschicht (5) gebildet ist. Auf die dem Substrat (4) abgewandte Seite der Epitaxieschicht (5) ist ein die hochdotierte Schicht (6,15) zumindest teilweise überdeckendes Schottkymetall (11) aufgebracht zur Bildung eines Schottky-Übergangs (13,18) zwischen dem Schottkymetall und der Epitaxieschicht (5).

## Beschreibung

Die Erfindung bezieht sich auf ein Halbleiter-Bauelement mit wenigstens einer hochdotierten Diode, insbesondere mit einer Zenerdiode oder Tunneldiode und wenigstens einer dazu parallel geschalteten Schottky-Diode, das auf einem hochdotierten Substrat eines ersten Dotierungstyps eine niedrig dotierte Epitaxieschicht des gleichen Dotierungstyps aufweist, wobei in die Epitaxieschicht eine Zone eines zweiten Dotierungstyps eindiffundiert ist und wobei auf der dem Substrat abgewandten Seite der Epitaxieschicht ein Schottky-Übergang zwischen der Epitaxieschicht und einem Schottkymetall ausgebildet ist.
Außerdem bezieht sich die Erfindung auf Verfahren zum Herstellen solcher Halbleiter-Bauelemente.
Zener-Dioden üblicher Bauart weisen wegen des vergleichsweisen hohen Spannungsabfalls in Flußrichtung eine entsprechend hohe Verlustleistung auf. Bei sogenannten Doppel-Zener-Dioden die durch antiparallele pn-Übergänge realisiert sind, addiert sich zur Zener-Spannung der einen Diode die Flußspannung der anderen Diode. Die Flußspannung ist aufgrund des Bahnwiderstands größeren Prozeßschwankungen unterworfen, so dass dementsprechend auch entsprechende Exemplarstreuungen auftreten.

Aus der JP 8-107 222 A ist ein Halbleiter-Bauelement mit einer Zenerdiode bekannt, das auf einem hochdotierten Substrat eines ersten Dotierungstyps (N+) eine niedrig dotierte Epitaxieschicht des gleichen Dotierungstyps (N-)aufweist, wobei in die Epitaxieschicht eine Zone eines zweiten Dotierungstyps (P) eindiffundiert ist und wobei auf der dem Substrat abgewandten Seite der Epitaxieschicht ein Schottky-Übergang zwischen der Epitaxieschicht und einem Schottkymetall ausgebildet ist.
Der Schichtaufbau dieses Halbleiter-Bauelementes ist vergleichsweise aufwendig und es sind dementsprechend viele Diffusionsvorgänge und Lithographieschritte erforderlich, was die Herstellung des Bauelementes verteuert.
So sind unter anderem zwei Metallisierungen für den Schottky-Übergang und den Zener-Übergang erforderlich. Außerdem müssen den Schottky-Übergang umgrenzende Schutzringe in separaten Schritte hergestellt werden.
Durch die Lage des Zener-Übergangs innerhalb der Epitaxieschicht und den einen am Substrat kontaktierenden Außenanschluß, fließt der Diodenstrom durch die vergleichsweise schlecht leitende Epitaxieschicht,sodasseinerhöhterdifferenziellerZenerwiderstand vorhanden ist.

Aus der JP 62-165 978 A ist ein Halbleiter-Bauelement bekannt, das auf einem Substrat einen eindiffundierten Bereich und dort einen Schottky-Übergang aufweist. Entgegengesetzte Leitungstypen und doppelt diffundierte Bereiche sind am Umfang der Schottky-Elektrode und eine ohmsche Elektrode ist im äußeren Bereich vorgesehen. Eine Zenerdiode ist durch die doppelt diffundierten Bereiche gebildet.
Mit dieser Konstruktion ist einerseits eine Schottkydiode gebildet, die eine sehr kurze Schaltzeit aufweist und andererseits eine parallel geschaltete Zenerdiode, deren Zenerspannung so bemessen ist, dass die in Sperrichtung gegen Überspannungen empfindliche Schottkydiode vor Spannungsspitzen geschützt ist.
Der durch die doppelt diffundierten Bereiche gebildet Zenerübergang erstreckt sich etwa rechtwinklig zur Oberseite der Anordnung. Dadurch nimmt die Diffusionskonzentration gleichermaßen für beide Bereiche von der Oberfläche nach innen ab. Durch dieses Konzentrationsgefälle ist nur ein sehr schmaler, oberflächennaher Bereich für den Zenerübergang wirksam, so dass dadurch nur eine geringe Strombelastbarkeit der Zenerdiode vorhanden ist.
Durch die unsymmetrische Schichtanordnung sind zwei Fotolitographieschritte notwendig, wodurch der Aufwand erhöht ist. Außerdem sind auch zwei Anschlüße nebeneinander angeordnet, so das sich eine schlechte Flächenausnutzung der Halbleiteranordnung ergibt.

Aufgabe der Erfindung ist es, ein Halbleiter-Bauelement mit einer Zener-Diode zu schaffen, welches verbesserte elektrische Eigenschaften und dabei insbesondere eine geringe Flußspannung und bedarfsweise einen verringerten Temperaturkoeffizienten aufweist.
Außerdem soll ein Herstellungsverfahren für solche Halbleiter-Bauelemente mit geringem Aufwand durchführbar sein.

Zur Lösung der Aufgabe wird hinsichtlich der Vorrichtung einerseits vorgeschlagen, dass die Zone des zweiten Dotierungstyps eine hochdotierte Zone ist, die sich zur Bildung eines pn-Zenerübergangs in der Nähe der Grenzfläche zwischen Substrat und Epitaxieschicht bis zum Substrat erstreckt und dass das Schottkymetall die eindiffundierte Zone zumindest teilweise überdeckt.

Durch den Schottky-Übergang ist der Zener-Diode eine Schottky-Diode parallel geschaltet, die in Flußrichtung der Zener-Diode den Stromfluß übernimmt und an der nur ein geringer Spannungsabfall und dementsprechend auch eine geringe Verlustleistung auftritt.
Bei diesem Halbleiter-Bauelement ergeben sich trotz des sehr einfachen Aufbaus besonders gute, elektrische Eigenschaften. Dies betrifft insbesondere auch die Strombelastbarkeit und den Durchgangswiderstand, weil einerseits der Zener-Übergang problemlos an die geforderte Strombelastbarkeit anpaßbar ist und weil außerdem im Stromverlauf keine widerstandserhöhenden Schichten vorhanden sind. Dies trägt mit zu einer geringen Verlustleistung bei.

Das Verfahren zum Herstellen eines solchen Halbleiter-Bauelementes sieht vor, dass auf ein hochdotiertes Substrat eines ersten Dotierungstyps eine niedrig dotierte Epitaxieschicht des gleichen Dotierungstyps aufgebracht wird, dass anschließend in die Epitaxieschicht eine hochdotierte Zone eines zweiten Dotierungstyps eindiffundiert wird, die sich zur Bildung eines pn-Zenerübergangs in der Nähe der Grenzfläche zwischen Substrat und Epitaxieschicht bis zur Substratschicht erstreckt und dass auf die dem Substrat abgewandte Seite der Epitaxieschicht ein den Bereich der eindiffundierten Zone zumindest teilweise überdeckendes Schottkymetall aufgebracht wird zur Bildung eines Schottky-Übergangs zwischen der Epitaxieschicht und dem Schottkymetall.
Dieses Verfahren ist mit wenigen Lithographieschritten und Diffusionsvorgänge durchführbar. Insbesondere ist auch nur eine einzige Metallisierung erforderlich und beim Eindiffundieren der hochdotierten Zone in die Epitaxieschicht zur Bildung des pn-Zenerübergangs wird gleichzeitig ein Schutzring für den Schottky-Übergang gebildet, so dass dafür kein separater Verfahrensschritt erforderlich ist.
InsgesamtkannderHerstellungsaufwandgegenüberbisherigenVerfahren zum Herstellen solcher Halbleiter-Bauelement etwa halbiert werden.

Nach einer anderen Ausführungsform, für die selbständiger Schutz beansprucht wird, ist bei einem Halbleiter-Bauelement nach dem Oberbegriff des Anspruches 2 vorgesehen, dass in das hochdodierte Substrat des ersten Dotierungstyps bereichsweise eine hochdotierte Schicht eines zweiten Dotierungstyps zur Bildung eines pn-Zenerübergangs eingebracht ist, dass sich von dieser hochdotierten Schicht im Substrat in die Epitaxieschicht ein niedrig dotierter Bereich des zweiten Dotierungstyps bis an die Oberfläche der Epitaxieschicht erstreckt und dass das Schottkymetall den niedrig dotierten, eindiffundierten Bereich zumindest teilweise überdeckt zur Bildung eines weiteren Schottky-Übergangs zwischen diesem Bereich und dem Schottkymetall und des Schottky-Übergangs zwischen dem Schottkymetall und der Epitaxieschicht.

Bei dieser Ausführungsform ist durch die Reihenschaltung von gegensätzlich gepolter Zener-Diode und Schottky-Diode eine Zener-Diode mit einem niedrigen Temperaturkoeffizienten gebildet, wenn die Zener-Diode einen positiven Temperaturkoeffizienten hat, was bei etwa 5,6 Volt der Fall ist. Außerdem wird durch die in Flußrichtung der Zener-Diode gepolte, zu der Reihenschaltung aus Zener-Diode und der ersten Schottky-Diode parallel geschalteten Schottky-Diode eine niedrige Flußspannung erreicht.

Nach einer Weiterbildung der Erfindung besteht auch die Möglichkeit, dass auf einem gemeinsamen Substrat nebeneinander der Schichtaufbau gemäß Anspruch 1 oder Anspruch 2 aufgebracht ist.
In Kombination mit den Merkmalen von Anspruch 1 erhält man so antiparallel geschaltete Anordnungen, wobei die beiden antiparallel geschalteten Zweige jeweils eine Zener-Diode und eine parallel geschaltete Schottky-Diode aufweisen.

In Kombination mit den Merkmalen gemäß Anspruch 2 erhält man antiparallel geschaltete Anordnungen jeweils mit gegensinnig in einer Reihenschaltung angeordneter Zener-Diode und Schottky-Diode und einer zu dieser Reihenschaltung parallel geschalteten, zur Zener-Diode gleich gepolten weiteren Schottky-Diode.

Bei beiden Anordnungen mit antiparallel geschalteten Diodengruppen ergibt sich neben einem niedrigeren Temperaturkoeffizienten in einem bestimmten Zenerspannungsbereich eine Schutzfunktion bei Überspannungen. Durch die antiparallele Anordnung werden Überspannungen auch unterschiedlicher Polarität abgeleitet.

Die das Verfahren zum Herstellen der erfindungsgemäßen Halbleiter-Bauelemente kennzeichnenden, weiteren Merkmale sind in den Ansprüchen 5 und 6 wiedergegeben.
Nachstehend ist die Erfindung mit ihren wesentlichen Einzelheiten anhand der Zeichnungen noch näher erläutert. Es zeigt:
- Fig. 1: einen Querschnitt einer Diodenanordnung mit einer zu einer Zener-Diode parallel geschalteter Schottky-Diode,
- Fig. 2: eine zu der Fig. 1 analoge Diodenschaltung,
- Fig. 3: einen Querschnitt durch eine Diodenanordnung mit einer antiparallel zu einer Zener-Diode geschalteten Schottky-Diode sowie einer parallel zu dieser Reihenschaltung angeordneten Schottky-Diode,
- Fig. 4: eine zu der Fig. 3 analoge Diodenschaltung,
- Fig. 5: einen Querschnitt durch zwei nebeneinander angeordnete Diodenanordnungen gem. Fig. 3,
- Fig. 6: eine Schaltsymbolanordnung analog zu der Ausführungsform gemäß Fig. 5,
- Fig. 7: einen Querschnitt einer Diodenanordnung etwa entsprechend Figur 1, hier jedoch mit einer zusätzlichen Trägerschicht sowie nebeneinander angeordneten Außenanschlüssen und
- Fig. 8: einen Querschnitt einer Diodenanordnung etwa entsprechend Figur 5, hier jedoch mit einer zusätzlichen Trägerschicht.

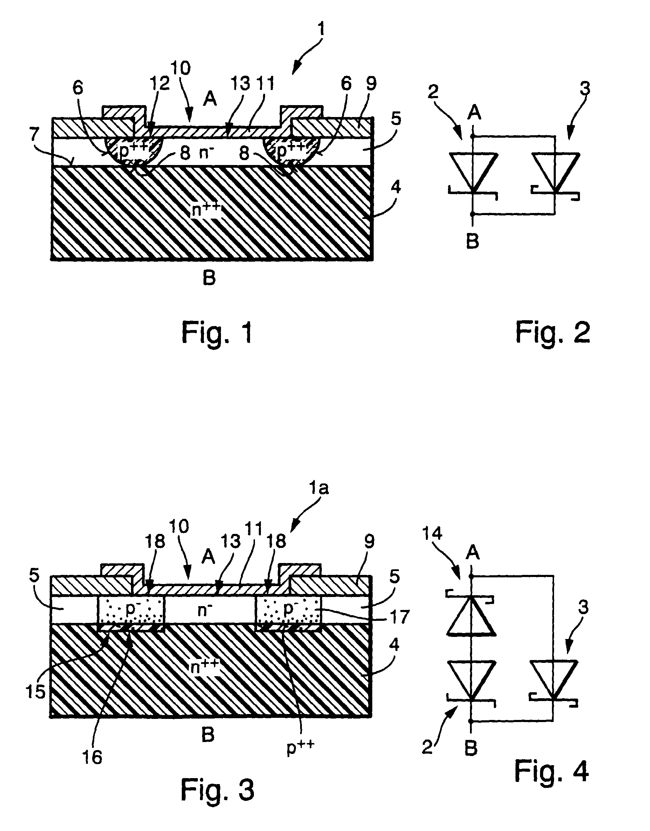

In den Zeichnungsfiguren sind die Außenanschlüsse des jeweiligen Halbleiter-Bauelementes 1, 1a bis 1d mit A und B gekennzeichnet.
Ein in Fig. 1 gezeigtes Halbleiter-Bauelement 1 bildet, wie in Fig. 2 anhand der äquivalenten Schaltung gezeigt, eine Parallelschaltung aus einer Zener-Diode 2 und einer Schottky-Diode 3. Das in Fig. 1 gezeigte Bauelement weist dazu ein hochdotiertes Substrat 4 eines ersten Dotierungstyps auf, auf das eine niedrig dotierte Epitaxieschicht 5 des gleichen Dotierungstyps aufgebracht ist. In die Epitaxieschicht 5 ist eine ringförmige, hochdotierte Zone 6 eines zweiten Dotierungstyps eindiffundiert, wobei sich diese Diffusionszone 6 zumindest bis an die Grenzfläche 7 zwischen Substrat 4 und Epitaxieschicht 5 erstreckt. Zwischen den beiden hochdotierten Bereichen unterschiedlichen Dotierungstyps ist dadurch ein Zener-pn-Übergang 8 und damit die Zener-Diode 2 gemäß Fig. 2 gebildet.
Auf der Epitaxieschicht 5 befindet sich eine Isolatorschicht 9 mit einer Fensteröffnung 10. Diese Fensteröffnung 10 wird durch eine Schottky-Metallschicht 11 überdeckt die ihrerseits zumindest teilweise die ringförmige Diffusionszone 6 kontaktiert. Zwischen der hochdotierten Zone 6 und der Schottky-Metallschicht 11 ist ein Ohmscher-Übergang 12 gebildet.
Die Schottky-Metallschicht 11 kontaktiert außer mit der ringförmigen Zone 6 auch flächig die zwischen der ringförmigen Zone befindliche Epitaxie-Schicht 5 und es ist zwischen diesen beiden Schichten ein flächiger Schottky-Übergang 13 und somit die Schottky-Diode 3 gemäß Fig. 2 gebildet.
Durch die Parallelschaltung der Schottky-Diode 3 zu der Zener-Diode 2 ist praktisch eine Zener-Diode mit geringer Flußspannung gebildet, so dass dementsprechend in Flußrichtung eine verringerte, im wesentlichen halbierte Verlustleistung gegenüber einfachen Zener-Dioden vorhanden ist.

Bei der in Fig. 4 gezeigten Schaltung ist zusätzlich zu der Anordnung gemäß Fig. 2 eine Schottky-Diode 14 antiparallel in Reihe zu der Zener-Diode 2 geschaltet.
Mit Hilfe dieser Schaltungsanordnung wird zusätzlich zu der verringerten Flußspannung ein niedrigerer Temperaturkoeffizient in einem bestimmten Zenerspannungsbereich erreicht, was sich insbesondere ab Zenerspannungen von etwa 5 Volt vorteilhaft bemerkbar macht.

Fig. 3 zeigt in einer Querschnitt-Darstellung den Aufbau eines Halbleiterbauelementes 1a entsprechend der in Fig. 4 gezeigten Dioden-Schaltungsanordnung.
Zur Herstellung eines solchen Halbleiterbauelementes 1a wird auf einem hochdotierten Substrat 4 eines ersten Dotierungstyps bereichsweise, insbesondere ringförmig eine hochdotierte Schicht 15 des zweiten Dotierungstyps zur Bildung eines Zener-Pn-Übergangs 16 eingebracht.
Während dem Aufbringen einer niedrig dotierten Epitaxie-Schicht 5 des ersten Dotierungstyps wird durch Autodoping aus der hochdotierten Schicht 15 des zweiten Dotierungstyps ein niedrig dotierter Bereich 17 hergestellt, der sich bis an die Oberfläche der Epitaxie-Schicht 5 erstreckt.

Auch in diesem Ausführungsbeispiel ist die Epitaxie-Schicht 5 durch eine Isolator-Schicht 9 mit einer Fensteröffnung 10 bereichsweise abgedeckt und die Fensteröffnung 10 ist durch eine Schottky-Metallschicht 11 überdeckt. Der niedrig dotierte Bereich 17 des zweiten Dotierungstyps kontaktiert mit der Schottky-Metallschicht 11 und bildet einen Schottky-Übergang 18 entsprechend der Schottky-Diode 14 in Fig. 4.
Parallel zu der Reihenschaltung aus antiparallel geschalteter Zener-Diode 2 und Schottky-Diode 14 (Fig. 4) entsprechend dem Zener-Pn-Übergang 16 und dem Schottky-Übergang 18, ist die Schottky-Diode 3 (Fig. 4) geschaltet. In Fig. 3 befindet sich der Schottky-Übergang 13 zwischen der Schottky-Metallschicht 11 und der zwischen dem ringförmigen Bereich 17 befindlichen Epitaxie-Schicht 5.

Sowohl die Anordnung gemäß Fig. 1 als auch gemäß Fig. 3 lassen sich mehrfach nebeneinander auf einem Substrat herstellen. Zwei Anordnungen gemäß Fig. 1 nebeneinander würden zwei Diodengruppen jeweils mit einer Parallelschaltung bestehend aus einer Zener-Diode 2 und einer Schottky-Diode 3 ergeben. Die beiden Anordnungen wären dabei antiparallel zueinander geschaltet, wobei die Verbindungsstelle zwischen den beiden Gruppen dem Substrat 4 entsprechen würde.

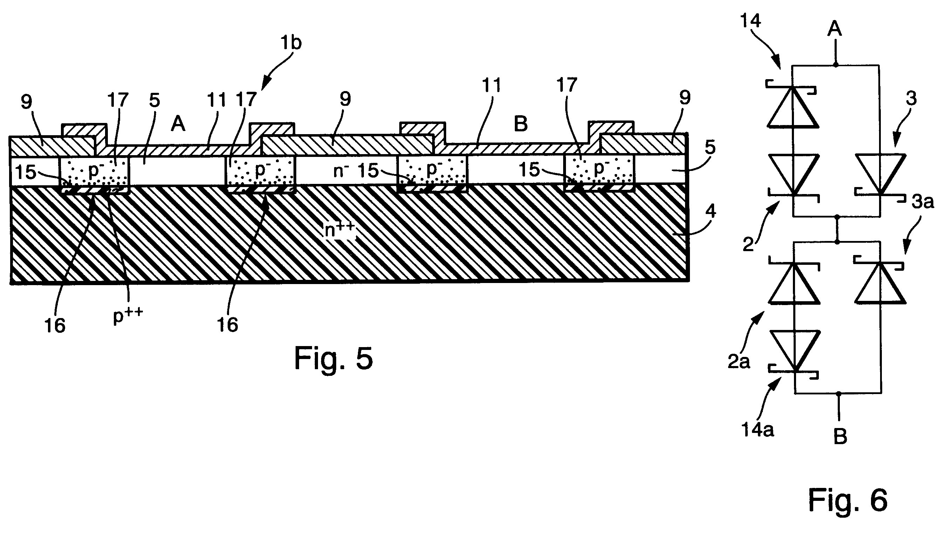

Fig. 5 zeigt ein Ausführungsbeispiel, bei dem die in Fig. 3 gezeigte Anordnung zweifach nebeneinander vorgesehen ist. Die zugehörige Schaltung zeigt Fig. 6. Bei mehreren Anordnungen gemäß Fig.1 oder Fig. 3 nebeneinander können die einzelnen Gruppen von Dioden - Zener-Diode 2 und Schottky-Diode 3 bzw. Zener-Diode 2 und die beiden Schottky-Dioden 3 und 14 - als separate Halbleitersysteme innerhalb einer Schaltung eingesetzt werden, wobei beachtet werden muß, dass durch das gemeinsame Substrat dementsprechend auch eine elektrische Verbindung zwischen den einzelnen Systemen vorhanden ist. Durch die direkte Anordnung der Systeme nebeneinander weisen diese praktisch keine Fertigungstoleranzen und somit weitestgehend gleiche Parameter bzw. gleich gute elektrische Eigenschaften auf.

Werden zwei Systeme wie in Fig. 6 gezeigt eingesetzt, wobei nur die Außenanschlüsse A und B verwendet werden, so ist eine Zener-Dioden-Anordnung gebildet, die einerseits durch die in Reihe zu den Zener-Dioden 2, 2a geschalteten Schottky-Dioden 14, 14a einen niedrigeren Temperaturkoeffizienten in einem bestimmten Zenerspannungsbereich aufweist und andererseits ist bei dieser Anordnung durch die Schottky-Dioden 3, 3a eine Überspannungs-Schutzfunktion unabhängig von der an den Außenanschlüssen A und B vorhandenen Polarität der anstehenden Spannung vorhanden.

Wenn die Anordnung gemäß Fig. 1 zweifach nebeneinander vorgesehen ist, können, wie bereits vorerwähnt, die einzelnen Systeme für sich innerhalb einer Schaltung eingesetzt werden, andererseits würde sich aber durch eine Antiparallel-Schaltung von zwei Gruppen, jeweils bestehend aus Zener-Diode 2 und Schottky-Diode 3, ebenfalls eine Schutzfunktion für die Zener-Diodensysteme ergeben, da Überspannungen unterschiedlicher Polarität abgeleitet werden.

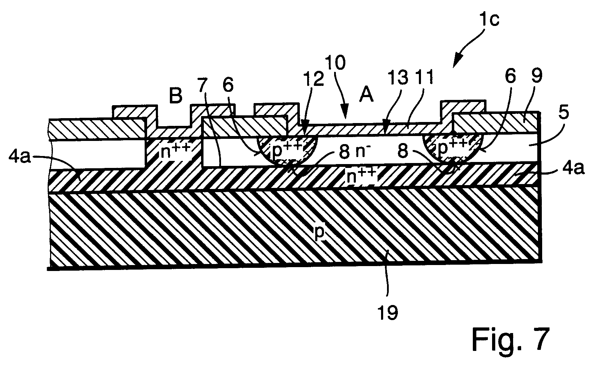

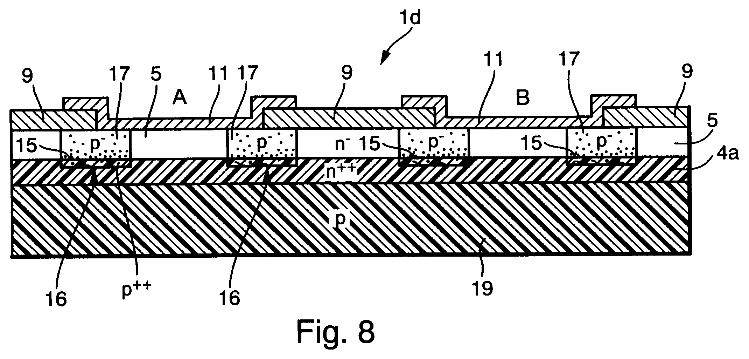

Die Figuren 7 und 8 zeigen noch den Schaltungen nach Figur 2 und 6 entsprechende Halbleiter-Bauelemente, bei denen in Abweichung zu den Figuren 1 und 5 auf dem hochdotierten Substrat 4, der Epitaxieschicht 5 abgewandt, eine Trägerschicht 19 aus p-dotiertem Halbleitermaterial vorgesehen ist.
Die Substratschicht 4a ist in diesem Fall vergleichsweise dünn, weil bei dieser Anordnung die Trägerschicht 19 die mechanische Stabilisierung übernimmt. Vorteilhaft ist diese Anordnung auch wegen der besseren Integrationsmöglichkeit in integrierten Schaltungen, weil bei diesen grundsätzlich p-Trägerschichten verwendet werden.
Die Außenanschlüsse A und B sind an der der Trägerschicht 19 abgewandten Seite des Bauelementes 1c,1d angeordnet.
Da der wirksame Bereich für den Stromfluß in der hochdotierten (n++) Substratschicht 4a vergleichsweise schmal ist, kann diese entsprechend dünn ausgebildet sein und beispielsweise eine Dicke von etwa einem Mikrometer aufweisen, während die Schichtdicke der zur mechanischen Stabilisierung dienenden Trägerschicht 19 100 Mikrometer oder mehr betragen kann.

Durch die sehr dünne Substratschicht 4a besteht auch die Möglichkeit, diese so hoch zu dotierten, dass sich bei den sonst Zenerdioden bildenden pn-Übergängen 8, 16 ein Tunneldiodeneffekt einstellt und damit eine oder mehrere Tunneldioden gebildet werden können.
Halbleiter-Bauelemente mit Tunneldioden lassen sich in der Hochfrequenztechnik einsetzen.

## Patentansprüche

1. Halbleiter-Bauelement mit wenigstens einer hochdotierten Diode, insbesondere mit einer Zenerdiode oder Tunneldiode und wenigstens einer parallel geschalteten Schottky Diode,
- das auf einem hochdotierten Substrat (4) eines ersten Dotierungstyps eine niedrig dotierte Epitaxieschicht (5) des gleichen Dotierungstyps aufweist,
- wobei die Epitaxieschicht eine Zone (6) eines zweiten Dotierungstyps eindiffundiert ist und
- wobei auf der dem Substrat abgewandten Seite der Epitaxieschicht (5) ein Schottky-Übergang (13) zwischen der Epitaxieschicht und einem Schottkymetall ausgebildet ist,
**dadurch gekennzeichnet,**
- dass die Zone (6) des zweiten Dotierungstyps eine hochdotierte Zone ist, die sich zur Bildung eines pn-Zenerübergangs (8) in der Nähe der Grenzfläche zwischen Substrat (4) und Epitaxieschicht (5) bis zum Substrat (4) erstreckt, und
- dass das Schottkymetall die eindiffundierte Zone zumindest teilweise überdeckt.

2. Halbleiter-Bauelement mit wenigstens einer Zenerdiode und wenigstens einer dazu parallel geschalteten Schottky-Diode,
- das auf einem hochdotierten Substrat (4) eines ersten Dotierungstyps eine niedrig dotierte Epitaxieschicht (5) des gleichen Dotierungstyps aufweist,
- wobei in die Epitaxieschicht eine Zone (6) eines zweiten Dotierungstyps eindiffundiert ist und
- wobei auf der dem Substrat abgewandten Seite der Epitaxieschicht (5) ein Schottky-Übergang (13) zwischen der Epitaxieschicht und einem Schottkymetall ausgebildet ist,
**dadurch gekennzeichnet,**
- dass in das hochdotierte Substrat (4) des ersten Dotierungstyps bereichsweise eine hochdotierte Schicht (15) eines zweiten Dotierungtyps zur Bildung eines pn-Zenerübergangs (16) eingebracht ist,
- dass sich von dieser hochdotierten Schicht (15) im Substrat (4) in die Epitaxieschicht (5) ein niedrig dotierter Bereich (17) des zweiten Dotierungstyps bis an die Oberfläche der Epitaxieschicht (5) erstreckt und
- dass das Schottkymetall den niedrigdotierten, eindiffundierten Bereich (17) zumindest teilweise überdeckt zur Bildung eines weiteren Schottky-Übergangs (18) zwischen diesem Bereich (17) und dem Schottkymetall (11) und des Schottky-Übergangs (18) zwischen dem Schottkymetall und der Epitaxieschicht (5).

3. Halbleiter-Bauelement nach Anspruch 1 oder 2 dadurch gekennzeichnet, dass auf einem gemeinsamen Substrat (4) der Schichtaufbau gemäß Anspruch 1 oder Anspruch 2 benachbart nebeneinander angeordnet ist.

4. Halbleiter-Bauelement nach einem der Ansprüche 1 bis 3, dadurch gekennzeichnet, dass auf dem hochdotierten Substrat (4a), der Epitaxieschicht (5) abgewandt, eine Trägerschicht (19) aus p-dotiertem Halbleitermaterial vorgesehen ist und daß die Außenanschlüsse (A,B) an der der Trägerschicht (19) abgewandten Seite des Bauelementes angeordnet sind.

5. Halbleiter-Bauelement nach Anspruch 4, dadurch gekennzeichnet, dass die hochdotierte Substratschicht (4a) eine Dicke im Bereich von etwa einem Mikrometer und die Trägerschicht (19) eine Dicke im Bereich von etwa 100 Mikrometern oder mehr aufweist.

6. Halbleiter-Bauelement nach Anspruch 4 oder 5, dadurch gekennzeichnet, dass die Dotierung der dünne Substratschicht (4a) für einen Tunneldiodeneffekt zwischen dieser Substratschicht (4a) und einer angrenzenden, hochdotierten Schicht eines anderen Dotierungstyps dimensioniert ist.

7. Verfahren zum Herstellen eines Halbleiter-Bauelementes nach Anspruch 1 , **dadurch gekennzeichnet,** dass auf ein hochdotiertes Substrat (4) eines ersten Dotierungstyps eine niedrig dotierte Epitaxieschicht (5) des gleichen Dotierungstyps aufgebracht wird, dass anschließend in die Epitaxieschicht eine hochdotierte Zone (6) eines zweiten Dotierungstyps eindiffundiert wird, die sich zur Bildung eines pn-Zenerübergangs (8) in der Nähe der Grenzfläche (7) zwischen Substrat (4) und Epitaxieschicht (5) bis zur Substratschicht erstreckt und dass auf die dem Substrat abgewandte Seite der Epitaxieschicht (5) ein den Bereich der eindiffundierten Zone zumindest teilweise überdeckendes Schottkymetall (11) aufgebracht wird zur Bildung eines Schottky-Übergangs (13) zwischen der Epitaxieschicht (5) und dem Schottkymetall.

8. Verfahren zum Herstelllen eines Halbleiter-Bauelementes nach Anspruch 2, dadurch gekennzeichnet, dass in ein hochdotieres Substrat (4) eines ersten Dotierungstyps bereichsweise eine hoch dotierte Schicht (15) eines zweiten Dotierungstyps zur Bildung eines pn-Zenerübergang (16) eingebracht wird, dass anschließend beim Aufbringen einer niedrig dotierten Epitaxieschicht (5) des ersten Dotierungstyps auf das Substrat (4) durch Autodoping aus der in das Substrat eingebrachten, hochdotieren Schicht (15) des zweiten Dotierungstyps, innerhalb der Epitaxieschicht (5) ein niedrig dotierter Bereich (17) des zweiten Dotierungstyps erzeugt wird, der sich bis an die Oberfläche der Epitaxieschicht erstreckt, dass auf die dem Substrat abgewandte Seite der Epitaxieschicht (5) ein den niedrigdotieren, eindiffundierten Bereich (17) zumindest teilweise überdeckendes Schottkymetall (11) aufgebracht wird zur Bildung eines Schottky-Übergangs (18) zwischen diesem Bereich (17) und dem Schottkymetall (11) und eines weiteren Schottky-Übergangs (13) zwischen dem Schottkymetall und der Epitaxieschicht (5).

9. Verfahren nach Anspruch 7 oder 8, dadurch gekennzeichnet, dass auf einem gemeinsamen Substrat (4) benachbart nebeneinander der Schichtaufbau gemäß Anspruch 7 oder Anspruch 8 hergestellt wird.
